# EUROPEAN PATENT SPECIFICATION

(11) **EP 3 009 900 B1**
(45) Date of publication and mention of the grant of the patent: **22.01.2020**
(21) Application number: 14188631.7
(22) Date of filing: 13.10.2014
(51) Int. Cl.: G05B 19/042, G05B 15/02, G06F 17/50

(54) **Dynamic recommendation of elements suitable for use in an engineering configuration**
Dynamische Empfehlung von zur Verwendung in einer technischen Konfiguration geeigneten Elementen
Recommandation dynamique d'éléments appropriés pour être utilisés dans une configuration d'ingénierie

(43) Date of publication of application: 20.04.2016
(73) Proprietor: Siemens Aktiengesellschaft, 80333 München (DE)
(72) Inventor: Hegde, Shreeharsha, 560100 Bangalore Karnataka (IN); Komarla Nagaraju, Nagarjuna, 560078 Bangalore Karnataka (IN); Tiruveedula, Bhaskar Babu, 560029 Bangalore Karnataka (IN)
(74) Representative: Isarpatent

(56) References cited:
- EP-A1- 1 191 465
- EP-A2- 1 480 092
- WO-A1-2004/006032
- US-A1- 2003 055 742
- US-A1- 2006 009 880

## Description

The present invention relates to the field of engineering application and more particularly relates to dynamic recommendation of elements suitable for use in an engineering configuration.

Generally, an automation system such as industrial automation system comprises hardware devices, i.e., active and passive electrical and electronic devices, and software, i.e., multiplicity of computer programs which are executable by the active hardware devices.

Typically, the hardware devices in the automation system are configured through an engineering configuration. An engineering configuration is data representation of the hardware devices and the software of the automation system. The engineering configuration is generally created using an engineering station which is provided with an engineering application. The engineering application enables the users to search and select elements which represent the hardware devices from element libraries (also known as engineering catalogue) and create connections between the selected elements using connection objects. Further, the engineering application allows the users to set parameters for each of the selected elements associated with the engineering configuration. The software can also be produced in a similar manner using the engineering application. For example, the engineering application allows the users to search and select elements representing library calls from the element libraries and create computer program such as programming logic.

The engineering configuration is generally created through a series of user actions on a graphical user interface of the engineering application. During this process, every user has to search manually for each element in an element library window which comprises thousands of elements. Thus, it becomes time consuming and tedious affair to manually search for the desired elements in the element library window each time a new engineering configuration is being created using the engineering application. Moreover, the user has to remember name, type, category associated with the desired element for searching for the desired elements in the element library window, hence requires skilled personnel to create large complex engineering configurations.

US 2006/0009880 discloses a method and system for computer-based configuration of a condensing unit for a cooling system. According to the method, a list of condensing units is generated based on a selected starting path. A condensing unit is selected from the list of condensing units and reconfigured based on desired criteria. The plurality of starting paths include a change in existing product path, a search by own specification path and a cross competitive product path. In the search by the own specification path, the user can search for condensing unit models by entering search criteria. Once the search is performed, the search results tab provides a list of the various condensing unit models found based on the search criteria. The user selects the condensing unit from the search results.

US 2005/0198607 discloses an analysis tool for producing automation hardware necessary for controlling and/or monitoring a technical process to be automated. The analysis tool analyzes a description of a technical process, selects an element from the description and requests from the user further specification (parameters) of the selected element via a user dialog. The analysis tool accesses a database to determine which hardware components are suitable based on the specified parameters.

In light of the above, there exists a need for providing fast and easy access to elements in an elements database for use in an engineering configuration.

Therefore, it is an object of the present invention to provide a method and apparatus for dynamically recommending one or more elements from a plurality of elements which are suitable for use in the engineering configuration.

The object of the present invention is achieved by a method according to claim 1 for creating hardware engineering configuration for an automation system. The elements may include hardware devices, runtime objects, programming elements, etc. The engineering configuration may include hardware configuration, programming logic and HMI screens. The automation system may be an industrial automation system, a building automation system, a home automation system and so on. The method comprises detecting, using a processor, at least one user action associated with the engineering configuration that is being created using an engineering application. For example, the engineering application enables a user to create the engineering configuration via a graphical user interface screen. The engineering application comprises an editor window and an element library window. In an exemplary implementation, the processor detects the user action when a user opens a device view in the editor window of the engineering application.

The method further comprises dynamically determining at least one element suitable for use in the engineering configuration from a plurality of elements in response to the user action based on a pattern of user activity associated with the engineering configuration. For example, a pattern database comprises a plurality of patterns of user activity. Each pattern of user activity comprises a sequence of user actions typically performed during creation of similar type of engineering configurations. Each user action in the sequence of user actions indicates an element used by the user in the similar type of engineering configurations. According to the present invention, the pattern of user activity is identified from the pattern database in response to the detected user action based on pre-defined criteria. For example, the pattern of user activity is identified based on type of engineering configuration being created. Alternatively, the pattern of user activity is identified based on a unique identifier associated with the user. In an exemplary implementation, the detected user action is identified among the sequence of user actions in the identified pattern of user activity. A user action following the detected user action is determined using the pattern of user activity. Furthermore, an element likely to be used for the engineering configuration is determined from the user action. In certain cases, the user may have used different types of the element in the determined user action. In such a case, the determined user action may indicate different types of element used in the previous engineering configurations. Then, the method comprises determining different types of the element that were used following the detected user action using the pattern of user activity. In this manner, the element suitable for use in the engineering configuration is dynamically determined using the pattern of user activity associated with the engineering configuration. Accordingly, the method comprises displaying a graphical object representing the element on the graphical user interface screen for use in the engineering configuration. In an exemplary implementation, the graphical object representing the element is obtained from an elements database and displayed in the element library window. Thus, the element suitable for use in the engineering configuration being created is recommended to the user. Hence, the user can use the graphical object representing the element in the engineering configuration being created. Advantageously, the need for manually searching the graphical object representing the element in the element database is eliminated. As a result, time and effort required to create the engineering configuration is saved.

Additionally, the method comprises detecting selection of the graphical object representing the element for use in the engineering configuration. For example, when the user performs a drag and drop operation on the graphical object displayed on the graphical user interface screen, the selection of the graphical object for use in the engineering configuration is detected. Accordingly, the method comprises activating and transferring the selected graphical object from the element library window to the editor window. In other words, the graphical object representing the element is added to the engineering object being created by activating and transferring the graphical object. The method repeats the above steps as selection of the graphical object is considered as a new user action performed by the user during creation of the engineering object. Thus, the method comprises dynamically updating the graphical user interface screen displaying the graphical object representing the element based on the new user action.

Therein, the method comprises creating the engineering configuration using the element(s) recommended on the graphical user interface screen. The user completes the engineering configuration using the element(s) recommended on the graphical user interface screen. Thus, the time required to manually search for the element(s) in the elements database is saved and hence the time and effort required to create the engineering configuration is significantly reduced.

Therein, the method comprises updating rank of the element associated with the selected graphical object in a rank database. The rank database contains rank information associated with each of the plurality of elements. The rank information indicates a rank assigned to each of the plurality of elements. When the user selects the graphical object representing the element, the rank associated with the element is incremented and the rank information stored in the rank database is updated accordingly.

Therein, when different types of the element are identified using the pattern of user activity, the method comprises displaying graphical objects representing the different types of the element based on rank associated with the different types of the element.

Therein, the method comprises capturing a series of user actions performed by the user during creation of engineering configurations. The series of user actions represents the pattern of user activity. Each of the series of user actions is indicative of different types of the element used by the user during creation of the engineering configurations. Thus, the captured pattern of user activity is stored and used for recommending elements suitable for use in the engineering configuration being created. Advantageously, the time and effort required to manually search for elements for use in the engineering configuration in the elements database is saved. Therein, the method comprises updating the pattern of user activity associated with the engineering configuration. For example, the user action performed by the user may deviate from the series of user actions associated with the pattern of user activity during creation of the engineering configuration. In such case, the pattern of user activity is updated based on the deviating user action.

The object of the present invention is also achieved by an apparatus according to claim 10 for creating hardware engineering configuration for an automation system.
The apparatus comprises a processor, and a memory coupled to the processor and comprising an engineering application. The engineering application is stored in the form of machine-readable instructions in the memory and executable by the processor. The engineering application is capable of detecting at least one user action associated with an engineering configuration being created for an automation system. The engineering application is capable of dynamically determining at least one element suitable for use in the engineering configuration from a plurality of elements in response to the user action based on a pattern of user activity associated with the engineering configuration. The engineering application is capable of displaying a graphical object representing the at least one element for use in the engineering configuration.

Therein, the engineering application is capable of displaying graphical objects representing different types of the element based on rank associated with the different types of the element.

Therein, the engineering application is capable of detecting selection of the graphical object representing the at least one element for use in the engineering configuration. The engineering application is further capable of activating and transferring the selected graphical object in an editor window.

Therein, the engineering application is capable of capturing a series of user actions performed by the user during creation of engineering configurations. The series of user actions represents the pattern of user activity. Each of the series of user actions is indicative of different types of the element used by the user during creation of the engineering configurations.

The apparatus may be an engineering station such as a desktop computer, a server computer, a laptop computer, a tablet, a smart phone and the like. The apparatus provides quick access to elements in the elements database which are suitable for use in the engineering configuration being created. Hence, the time and effort required to manually search the elements from the elements database is significantly saved.

The above-mentioned and other features of the invention will now be addressed with reference to the accompanying drawings of the present invention. The illustrated embodiments are intended to illustrate, but not limit the invention.

The present invention is further described hereinafter with reference to illustrated embodiments shown in the accompanying drawings, in which:
- FIG 1: is a block diagram illustrating an exemplary engineering station configured for generating an engineering configuration according an embodiment of the present invention.
- FIG 2: illustrates a block diagram of an element library module of FIG 1 according to an embodiment of the present invention.
- FIG 3: is a process flowchart illustrating an exemplary method of dynamically recommending elements for use in the engineering configuration using an engineering application of FIG 1 according to an embodiment of the present invention.
- FIG 4: illustrates a block diagram of a distributed control system capable of dynamically recommending elements for use in engineering configurations according to one embodiment of the present invention.
- FIGs 5A-5C: illustrates screenshot views of an engineering Graphical User Interface (GUI) editor displaying a configuration editor window on the engineering station of FIG 1 according to one embodiment of the present invention.
- FIGs 6A-6B: are screenshot views of the engineering GUI editor displaying a screen editor window on the engineering station of FIG 1 according to another embodiment of the present invention.
- FIG 7: illustrates a screenshot view of the engineering GUI editor displaying a programming editor window on the engineering station of FIG 1 according to yet another embodiment of the present invention.

Various embodiments are described with reference to the drawings, wherein like reference numerals are used to refer the drawings, wherein like reference numerals are used to refer to like elements throughout. In the following description, for the purpose of explanation, numerous specific details are set forth in order to provide thorough understanding of one or more embodiments. It may be evident that such embodiments may be practiced without these specific details.

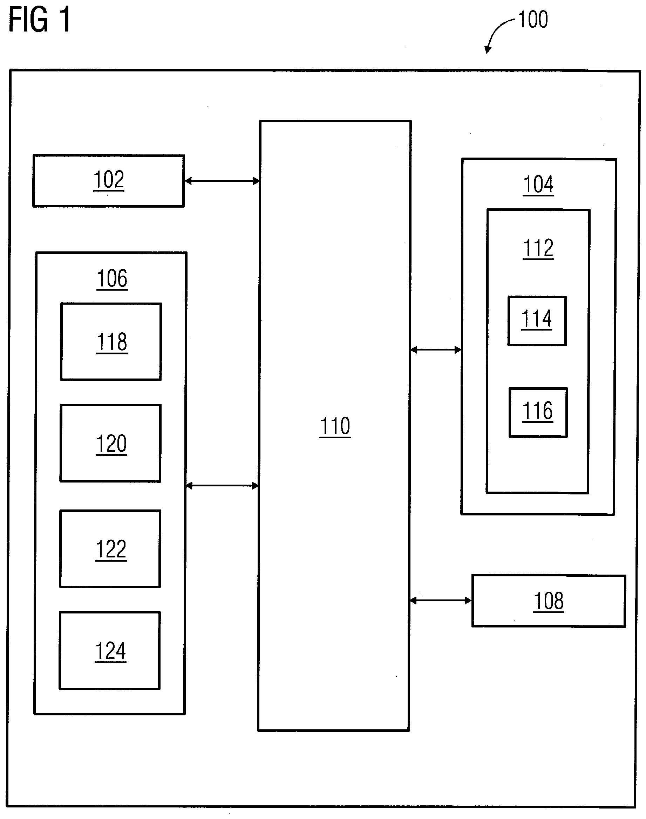

FIG 1 is a block diagram illustrating an exemplary engineering station 100 configured for generating an engineering configuration according an embodiment of the present invention. The engineering station 100 may be a desktop computer, a laptop computer, a server computer, a tablet and the like. In FIG 1, the engineering station 100 comprises a processor 102, a memory 104, a storage unit 106, input/output devices 108, and a bus 110.

The processor 102, as used herein, means any type of computational circuit, such as, but not limited to, a microprocessor, a microcontroller, a complex instruction set computing microprocessor, a reduced instruction set computing microprocessor, a very long instruction word microprocessor, an explicitly parallel instruction computing microprocessor, a graphics processor, a digital signal processor, or any other type of processing circuit. The processor 102 may also include embedded controllers, such as generic or programmable logic devices or arrays, application specific integrated circuits, single-chip computers, and the like.

The memory 104 may be volatile memory and non-volatile memory. A variety of computer-readable storage media may be stored in and accessed from the memory 104. The memory 104 may include any suitable elements for storing data and machine-readable instructions, such as read only memory, random access memory, erasable programmable read only memory, electrically erasable programmable read only memory, hard drive, removable media drive for handling compact disks, digital video disks, diskettes, magnetic tape cartridges, memory cards, and the like. As depicted, the memory 104 comprises the engineering application 112 stored in the form of machine-readable instructions on any of the above-mentioned storage media and may be executed by the processor 102. For example, when executed by the processor 102, the engineering application 112, cause the processor 102, to provide an engineering graphical user interface (GUI) editor for creating engineering configurations for an automation system such as an industrial automation system deployed in an industrial setting. The engineering GUI editor provides an editor window which displays an engineering configuration being created for the automation system, and an element library window which displays graphical objects representing elements suitable for use in the engineering configuration. For example, the engineering configuration may include hardware configuration of hardware devices in the automation system, runtime screens for human machine interface (HMI) devices, programming logic for programmable logic controllers and so on. The elements comprises hardware devices in the automation system such as programmable logical controller, communication controller, input/output devices, field devices, human machine interface devices, network switches and so on; runtime objects for HMI screens associated with a human machine interface device in the automation system such as control objects and basic objects; and programming elements for programming logic and so on.

The engineering application 112 comprises an engineering configuration creation module 114, and an element library module 116. The engineering configuration creation module 114, causes the processor 102, to create an engineering configuration for an automation system using the editor window. The engineering configuration creation module 114 enables a user to select desired elements from the element library window and create the engineering configuration in the editor window. The element library window displays graphical objects representing a plurality of elements such as hardware devices, Human Machine Interface (HMI) screen, runtime objects, programming elements, etc. from an elements database 118. In an exemplary implementation, the user drags and drops a desired graphical object from the element library window into the editor window during creation of the engineering configuration. Accordingly, the engineering configuration creation module 114 activates and transfers the graphical object to the editor window from the element library window. In this manner, the engineering configuration is created using the elements from the element library window.

According to the present invention, the element library module 116, causes the processor 102, to capture a series of user actions while the user creates the engineering configuration in the editor window. For example, the element library module 116 logs an event corresponding to each of the series of user actions in a pattern database 120. The event may indicate an element that is used by the user for creating the engineering configuration or a view opened by the user during creation of the engineering configuration. The series of user actions are actions sequentially performed by the user in real time while creating the engineering configuration. The series of user actions represent pattern of user activity during creation of the engineering configuration. It can be noted that, the pattern of user activity may be associated with different views such as device view, network view and so on. Thus, the element library module 116, causes the processor 102, to also store type of view associated with the recorded pattern of activity in the pattern database 122. For example, consider that the user creates a hardware configuration using the editor window. During creation of hardware configuration, the user adds a specific type of programmable logic controller (PLC) followed by specific type of I/O module and so on from the element library window. Accordingly, the processor 102 records and stores events associated with these actions carried out by the user as it is likely that the same user or other users may repeat the series of user actions performed during creation of the hardware configuration while creating another hardware configuration of similar type in future. Alternatively, the pattern of user activity can be pre-stored based on user actions likely to be performed to create a known engineering configuration. In such case, the pattern of user activity may be updated based on actions performed by the user during creation of the engineering configuration.

Later when the user wishes to create a new engineering configuration, the element library module 116, causes the processor 102, to detect a user action associated with the engineering configuration. For example, consider that the user opens a network view in the editor window. Accordingly, the processor 102 detects that the network view is opened in the editor window.

The element library module 116, causes the processor 102, to identify type of view opened in the editor window and determines a pattern of user activity associated with the identified type of editor view from the plurality of patterns of user activity. For example, the pattern database 120 may maintain a list of patterns of user activity associated with different type of editor views. If the editor view opened in the editor window is identified as network view, the processor 102 accesses the list of patterns of user activity for the network view and identifies one of the patterns of user activity from the list based on pre-defined criteria. The pre-defined criteria involve type of user and type of engineering configuration being created. For example, the processor 102 identifies one of the patterns of user activity based on identifier associated with the user creating the engineering configuration. Alternatively, the processor 102 identifies one of the patterns of user activity based on type of engineering configuration being created.

The element library module 116, causes the processor 102, to dynamically determine an element suitable for use in the engineering configuration being created in response to the detected user action. Thereafter, the element library module 116, causes the processor 102, to obtain graphical objects representing different types of the determined element from the element database 118 and display the graphical objects in the element library window. For example, according to the identified pattern of user activity, the user selects a central processing unit (CPU) from the element library window after opening the network view in the editor window. Accordingly, the processor 102 displays graphical objects representing different types of CPUs in the element library window so that the user can use one of the different types of CPUs displayed in the element library window to the engineering configuration.

In some embodiments, the element library module 116, causes the processor 102, to identify the different types of the recommended element from a plurality of types of the recommended element stored in the elements database 118 based on rank assigned to each type of the recommended element. The rank is assigned to each type of the recommended element based on number of times said each type of the recommended element was previously used for creating engineering configurations. For example, the user has used a first type of CPU four times, a second type of CPU twice and a third type of CPU once in previous engineering configurations, the first type of CPU is ranked highest as compared to the second and third types of CPU. The other types of CPUs, fourth, fifth, sixth and so on, are not ranked since they are not used by the user in the previous engineering configurations. Accordingly, the element library module 116, causes the processor 102, to determine rank associated with different types of CPU and display the graphical objects representing the different types of CPU according to the rank in the element library window. For example, the graphical object representing the first type of CPU is displayed at top while the graphical object representing the third type of CPU is displayed at the bottom in the element library window. Thus, the user can select a specific type of CPU from the different types of CPU displayed in the element library window based on the rank.

Once the user selects a specific type of the recommended element from the different types of the recommended element, the element library module 116, causes the processor 102, to detect selection of the specific type of the recommended element for use in the engineering configuration. For example, the processor 102 detects the selection of the specific type of the recommended element for use in the engineering configuration when the user drags and drops the graphical object representing the specific type of the recommended element from the element library window into the editor window. Accordingly, the element library module 116, causes the processor 102, to create an instance of the graphical object representing the specific type of the recommended element in the editor window. For example, the processor 102 activates and transfers the graphical object representing the first type of CPU when the user drags and drops the graphical object from the element library window. Also, the element library module 116, causes the processor 102, to increment rank associated with the specific type of the recommended element selected for use in the engineering configuration. For example, the processor 102 increments the rank of the first type of CPU by value '1' since the graphical object representing the first type of CPU is selected for use in the engineering configuration being created. Accordingly, the element library module 116, causes the processor 102, to update ranking information in a rank database 122 with the updated rank.

Then, the element library module 116, causes the processor 102, to consider selection of the specific type of the recommended element as a user action performed by the user. Accordingly, the element library module 116, causes the processor 102, to repeat the above steps according to the pattern of user activity in response to selection of the specific type of the recommended element. For example, consider that the user selects a slave device following selection of the CPU according to the pattern of user activity. In such case, the processor 102 dynamically determines that next element to be displayed in the element library window is a slave device since the user has currently selected the CPU in the engineering configuration. Accordingly, the processor 102 displays graphical objects representing different types of slave device in the element library window based on rank associated with the different types of slave device. The above process is repeated each time a user action is detected by the processor 102 until the completion of the engineering configuration. As a result, graphical objects displayed in the element library window gets refreshed each time a new graphical object is selected from the element library window for creating the engineering configuration.

It can be noted that, if user actions performed during creation of the engineering configuration deviates from the user actions in the identified pattern of user activity, then element library module 116 causes the processor 102 to update the identified pattern of user activity with the deviating user actions.

The storage unit 106 may be a non-transitory storage medium configured for storing databases. For example, the storage unit 106 contains the elements database 118 which stores graphical objects representing various elements useful for creating engineering configuration. The storage unit 106 contains the pattern database 120 which stores various patterns of user activity associated with the user or other users. In one embodiment, the pattern of user activity is based on actions performed by a particular user during creation of previous engineering configurations. In another embodiment, the pattern of user activity is based on standard actions that any user is likely to perform while creating a specific engineering configuration. In yet another embodiment, the pattern of activity is based on actions performed by other users during creation of same type of engineering configuration.

The storage unit 106 also contains the rank database 122 which stores ranking information associated with different types of the elements in each pattern of user activity. The ranking information indicates rank assigned to each of the different types of elements in each pattern of user activity. The rank information of said each type of element may include rank value, unique identifier of the pattern of user activity to which said each type of element belongs, an element identifier associated with said each type of element. The rank is assigned to each type of element based on number of times said each type of element is used for creating engineering configuration. For example, when said each type of element recommended in the element library window is selected for use in the engineering configuration being created, the rank associated with said each type of element is incremented and the rank information is incremented accordingly. Additionally, the storage unit 106 contains an engineering configuration database 124 which stores engineering configurations created using the engineering application 112.

The input/output devices 108 may include keyboard, keypad, monitor, touch sensitive display screen, mouse and the like. The input device/output devices 108 enable the user to interface with the engineering station 100 during creation of the engineering configuration. For example, the input device may enable drag and drop graphical objects representing elements from the element library window into the editor window. The output device may be graphical user interface screen which displays the editor window and the element library window. The bus 110 may acts as an interface between the processor 102, the memory 104, the storage unit 106 and the input/output module 108.

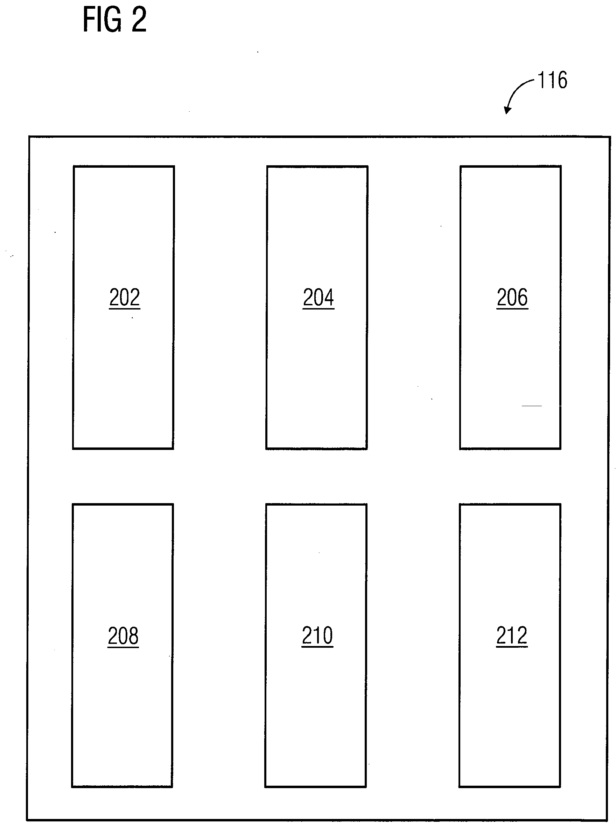

FIG 2 illustrates a block diagram of the element library module 116 of FIG 1 according to an embodiment of the present invention. The element library module 116 comprises a pattern capturing module 202, a user action detecting module 204, an element identification module 206, a display module 208, a selection module 210, and a ranking module 212.

The pattern capturing module 202 is configured to record events based on actions performed by a user during creation of engineering configuration such as a hardware configuration, HMI screens, a programming logic, and the like. The actions may include opening a device view in an editor window for creating a hardware configuration, adding a graphical object representing a CPU to the hardware configuration from an element library window, adding a graphical object representing a slave device to the hardware configuration that are performed in a sequential order. In this scenario, the recorded events may be device view -> CPU -> slave device -> and so on. The events corresponding to the user actions represent a pattern of user activity generally followed by the user during creation of the engineering configuration using the engineering application 112. The pattern capturing module 202 is configured to store the pattern of user activity in the pattern database 120. For example, the pattern of user activity is stored in the pattern database 120 in an extended markup language (XML) format. It can be noted that, the pattern of user activity can be also stored in any other compatible format. Also, the pattern capturing module 202 is configured to continuously learn user actions and update the pattern of user activity stored in the pattern database 120. For example, the pattern capturing module 202 detects an user action performed during creation of the engineering configuration and determines whether the detected user action is present in the pattern of user activity. For example, a unique identifier associated with the detected user action is compared with identifier associated with each user action in the pattern of user activity. If match is found, the detected user action is determined as present in the pattern of user activity. If the user action is not present in the pattern of user activity, then the pattern capturing module 202 updates the pattern of user activity. Alternatively, the pattern capturing module 202 may create a new pattern of user activity by adding the user action to the stored pattern of user activity and store the new pattern of user activity in the pattern database 120.

The user action detecting module 204 is configured for detecting a user action performed by the user during creation of an engineering configuration. For example, when the user opens a device view in an editor window to create an engineering configuration, the user action detecting module 204 detects the opening of the device view. Similarly, when the user adds a graphical object representing an element such as hardware device, programming element or runtime object from an element library window into the editor window, the user action detecting module 204 detects addition of the graphical object in the editor window.

The element identification module 206 is configured for identifying a pattern of user activity based on type of view opened in the editor window. For example, if the user has opened a device view, the element identification module 206 identifies a pattern of user activity corresponding to the device view. This ensures that the pattern of user activity corresponds to user actions likely to be performed in the device view. The element identification module 206 is configured for determining the detected user action among a series of user actions in the identified pattern of user activity. For example, if the detected user action corresponds to opening of device view, the element identification module 206 identifies action of opening the device view in the identified pattern of activity.

Also, the element identification module 206 is configured for determining an element that is used following the user action in the identified pattern of user activity. For example, if the pattern of user activity indicates that the user has selected a CPU upon opening the device view, then the element identification module 206 dynamically determines that the element used following opening of the device view is CPU. Accordingly, the element identification module 206 is configured for determining different types of the element that are used by the user according to the pattern of user activity. For example, if the pattern of user activity indicates that a first type of CPU is used five times while a second type of CPU is used eight times, then the element identification module 206 determines the different types of the element as first type of CPU and second type of CPU. Additionally, the element identification module 206 is configured for determining rank associated with the different types of the element from the rank database 122. For example, the rank database 122 stores rank information associated with different types of the element corresponding to the pattern of user activity. The rank information contains rank assigned to each type of element. In an exemplary implementation, the rank is assigned to each type of element based on usage of said each type of the element. The element identification module 206 accesses rank associated with each type of the element for the pattern of user activity in the rank database 122. Moreover, the element identification module 206 is configured for obtaining graphical objects corresponding to different types of the element from the elements database 118.

The display module 208 is configured for displaying the graphical objects representing the different types of the element in the element library window. The graphical objects represent the different types of the element recommended for use in the engineering configuration. In some embodiments, the display module 208 is configured for displaying the graphical objects according to the rank associated with the different types of the element. For example, the display module 208 displays the graphical object representing the second type of CPU on top followed by the graphical object representing the first type of CPU since the second type of CPU is ranked higher compared to the first type of CPU.

The selection module 210 is configured for detecting selection of one of the graphical objects representing the different types of the element from the element library window for use in the engineering configuration. For example, if the user selects the second type of CPU through a drag and drop operation, the selection module 210 detect the drag and drop operation performed on the graphical object representing the second type of CPU. The selection module 210 is also configured for activating and transferring the selected graphical object from the element library window to the editor window for use in the engineering configuration. As a result, an instance of the selected graphical object is created in the editor window. The ranking module 212 is configured for incrementing the rank associated with the type of the element selected for use in the engineering configuration. Also, the ranking module 212 is configured for updating the rank database 122 with the incremented rank.

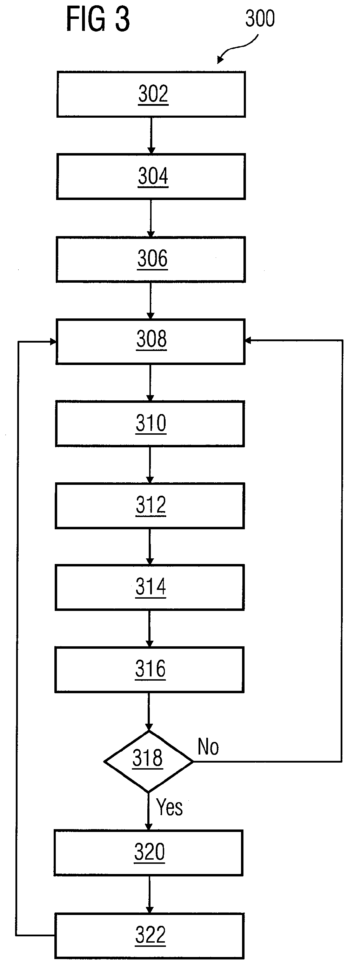

FIG 3 is a process flowchart 300 illustrating an exemplary method of dynamically recommending elements for use in an engineering configuration being created using the engineering application 112 according to an embodiment of the present invention. At step 302, an user action associated with the engineering configuration is detected. For example, the user action may involve opening a device view in an editor window. At step 304, type of view associated with the engineering configuration is being identified. For example, type of view may be a device view, a network view and so on.

At step 306, a pattern of user activity is identified from a plurality of patterns of user activity based on the type of view. For example, the pattern of user activity performed when a user works in a network view differs from the pattern of user activity performed when the user works in a device view. The pattern of user activity involves series of user actions likely to be performed for creating an engineering configuration. The pattern of user activity may be associated with the user, i.e., captured when the user was previously creating other engineering configurations of same type. Alternatively, the pattern of user activity may be a standard pattern typically followed during creation of same type of engineering configurations. Also, the pattern of user activity may be pattern of user activity captured when other users were creating same type of engineering configuration. It can be noted that, type of engineering configuration is determined in addition to the type of view for selecting the pattern of user activity if the pattern of user activity is selected based on the type of engineering configuration. Similarly, if the pattern of user activity is selected based on user information (e.g., unique identifier, login credentials, profile information), then user information is determined in addition to type of view before selecting the pattern of user activity.

At step 308, the detected user action is located in the pattern of user activity. For example, identifier associated with the detected user action is matched with series of user actions in the pattern of user activity. At step 310, different type of element which are likely to be used following the detected user action is determined from the pattern of user activity. For example, a user action following the matched user action is determined among the series of user actions in the pattern of user activity. Thereafter, different types of element corresponding to the determined user action are identified from the pattern of user activity. For example, element identifiers are extracted from the determined user action in the pattern of user activity. The element identifiers may be a serial number or a unique name assigned to the different types of element. It can be noted that, each user action in the pattern of user activity contains element identifier(s) of those element(s) which is previously used or likely to be used in the engineering configuration. Accordingly, different types of an element are determined based on the element identifier. For example, an element may be an I/O module and different types of the element may include different models of the I/O module that are used following the detected user action according to the pattern of user activity.

At step 312, rank information associated with the identified different types of element is obtained from the rank database 122. For example, each of the different types of element is assigned a rank based on usage of the different types of element. The usage of different types of element refers to number of times a particular type element is used in the engineering configuration. At step 314, graphical objects representing the different types of element are obtained from the elements database 118. For example, the graphical objects representing the different types of element are obtained based on the element identifiers associated with the different types of element. At step 316, the graphical objects representing the different types of element are displayed according to the rank in an element library window of an engineering GUI editor. If the user finds any of the graphical objects suitable for use, the user may select the graphical object from the element library window and transfer the graphical object from the element library window to the editor window displaying the engineering configuration being created. For example, the user may perform a drag and drop operation on any of the graphical objects.

At step 318, it is determined whether any selection event associated with any of the graphical objects is detected. For example, selection event may be a drag and drop operation, a right mouse click, a double mouse click, touch gesture, and so on. If the selection event associated with any graphical object is detected, then at step 320, an instance of the selected graphical object is automatically created in the editor window. For example, the instance is created by activating and transferring the selected graphical object from the element library window to the editor window. As a result, the selected graphical object is displayed in the editor window. The displayed graphical object thus becomes a part of the engineering configuration being created using the engineering application 112. If no selection event is detected, then the process 300 returns 308 after the user selects a graphical object representing a specific type of element not recommended. At step 322, the rank of the type of element associated with the selected graphical object is incremented in the rank database 122. The process 300 is then routed back to step 308 and steps 308 to 322 are repeated. In this manner, the elements are dynamically recommended for use in the engineering configuration based on the pattern of user activity. Thus, time and effort required to manually search desired elements in the elements database 118 for use in the engineering configuration is eliminated. Advantageously, significant amount of time typically required for creating the engineering configuration is saved.

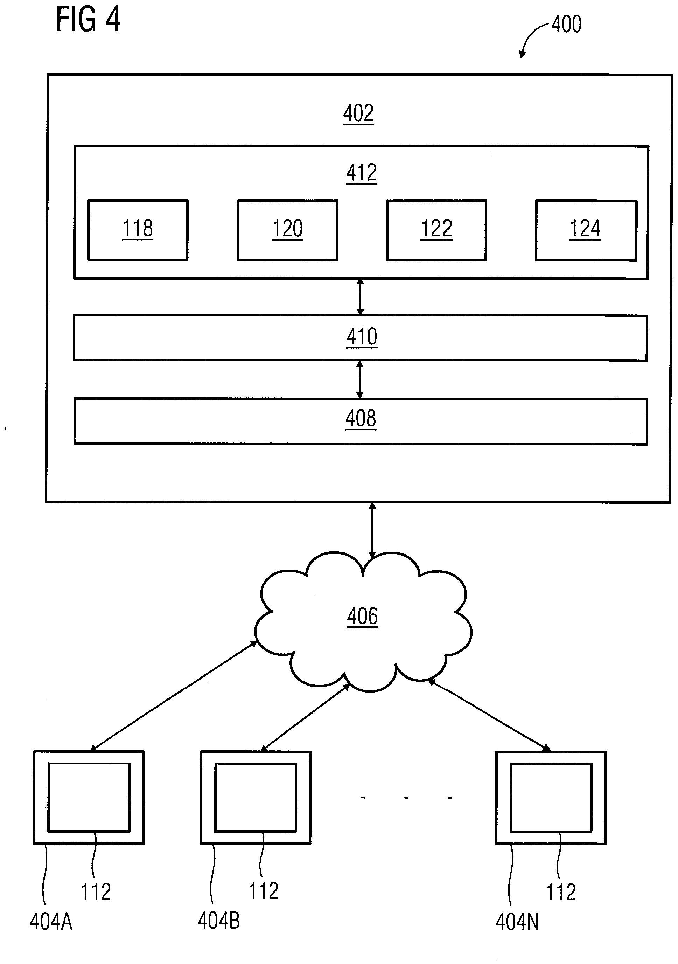

FIG 4 illustrates a block diagram of a distributed control system 400 capable of dynamically recommending elements for use in engineering configurations according to one embodiment of the present invention. The distributed control system 400 comprises a server 402, client devices 404A-N and a network 406. Each of the client devices 404A-N is communicatively coupled to the server 402 via the network interface 406.

The server 402 may be cloud computing server. The server 402 comprises a network interface 408, a processor 410, and a storage unit 412. The network interface 408 assists in communicating with the client devices 404A-N over the network 506. The processor 410 processes request received from each of the client devices 404A-N and provides response to said each of the client devices 404A-N. The storage unit 410 contains the elements database 118, the patterns database 120, the rank database 122, and the engineering configuration database 124. The network 406 may be Local Area Network, Wide Area Network, Wireless Local Area Network, and the like.

The client devices 404A-N may be a tablet computer, a desktop, a laptop, a smart phone, and the like devices. It is appreciated that the client devices 404A-N is an exemplary embodiment of the engineering station 100 of FIG 1. Although not shown, each of the client devices 404A-N may comprise an input module such as keyboard and mouse for providing input instructions, a processor for executing input instructions from a user, a memory for storing machine readable instructions, and a communication module for communicating with the server 102 via the network 106. As shown, each of the client devices 404A-N comprises the engineering application 112 stored in the form of machine-readable instructions on the memory (not shown) and executable by the processor (not shown) of respective client devices 404AN.

The engineering application 112 enables users of the respective client devices 404A-N to create an engineering configuration for use in automation system as described in FIG 1. According to the present invention, when the users of respective client devices 404A-N wishes to create desired engineering configuration using the engineering application 112, the client devices 404A-N sends a request for accessing the elements database 118, the pattern database 120, and the rank database 122 to the server 402 via the network 406. The server 402 provides access to the elements database 122, the pattern database 120, and the rank database 122. Accordingly, the engineering application 112 on the respective client devices 404A-N accesses these databases 118, 120, and 122 and dynamically recommends different types of element to the users in response to detected user action based on associated pattern of user activity as described in FIG 1. The pattern of user activity is selected from the pattern database 120 based on type of user, type of engineering configuration and type of view. In the distributed control system 400, since the pattern database 120 resides in the server 402, the client devices 404A-N gets accesses to patterns of user activity associated with multiple users of the distributed control system 400. This is because, whenever the engineering application 112 records a pattern of user activity on respective client devices 404A-N, the engineering application 112 stores the pattern of user activity in the pattern database 120. Hence, other client devices 404A-N in the distributed control system 400 can use the pattern of user activity whenever required.

Also, whenever rank associated with different types of elements is incremented during creation of engineering configurations, the respective client devices 404A-N updates rank information stored in the rank database 122. Additionally, when the engineering configurations are created, the respective client devices 404A-N stores the engineering configurations in the engineering configuration database 124. This assists the users to reuse the engineering configurations by accessing the engineering database 124.

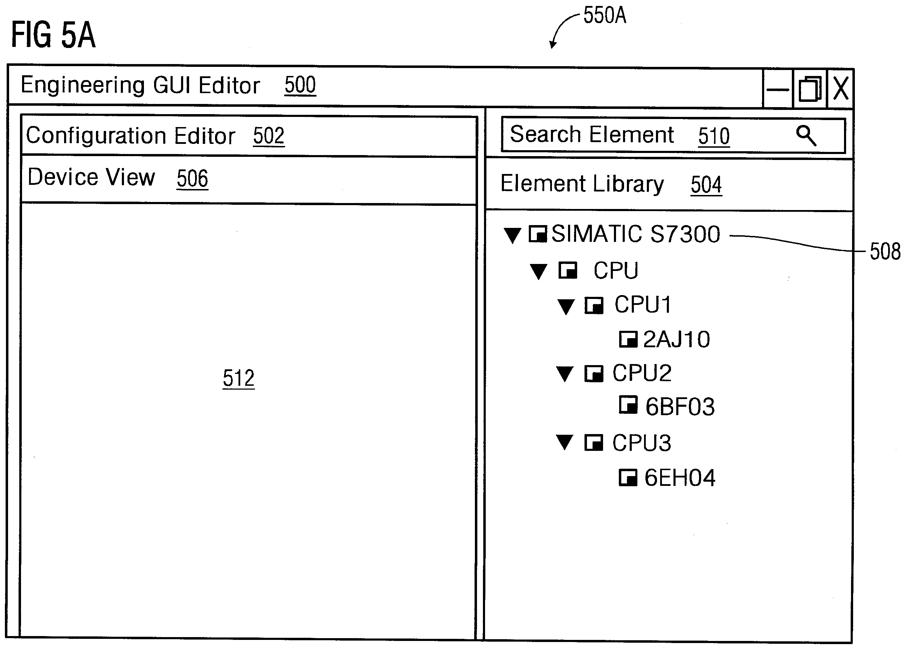

FIGs 5A-5C illustrates screenshot views 550A-C of an engineering GUI editor 500 displaying a configuration editor window 502 on the engineering station 100 according to one embodiment of the present invention. In FIG 5A, the engineering GUI editor 500 displays the configuration editor window 502 and an element library window 504. The configuration editor window 502 displays graphical objects representing elements of an engineering configuration being created using the engineering station 100. The configuration editor window 502 may display different views such as network view, device view and so on. The element library window 504 displays graphical objects representing elements recommended for use in the engineering configuration. For example, if the engineering configuration is a hardware configuration for an automation system, then the element library window 504 displays graphical objects representing hardware devices. Similarly, if the engineering configuration is associated with HMI screens for HMI devices in the automation system, then the element library window 504 displays graphical objects representing screen objects and runtime objects. According to the present invention, the element library window 504 dynamically displays graphical objects representing elements which are recommended for use in the engineering configuration being created in the configuration editor window 502. The recommendation of elements suitable for use in the engineering configuration is made based on pattern of user activity. For example, pattern of user activity may be associated with the user creating the engineering configuration. Also, the pattern of user activity may be associated with the type of engineering configuration being created. It is possible to determine elements likely to be used in the engineering configuration following each user action using the pattern of user activity since the pattern of user activity comprises a series of user actions typically performed during creation of such engineering configurations. Each user action in the series of user actions may indicate the element that is likely to be used in the engineering configuration being created by the user. Thus, the user need not have to manually search for graphical objects representing elements desired to be used in an engineering configuration in the elements database 118. Advantageously, time and effort required to manually search for graphical objects representing desired elements in the elements database 118 is saved.

Consider that the user wishes to create a hardware configuration for an automation system using the engineering GUI editor 500. Also, consider that the user opens a device view 506 in the configuration editor window 502 to create the desired hardware configuration. Accordingly, the engineering station 100 determines type of view opened by the user in the configuration editor window 502. Based on this, the engineering station 100 dynamically identifies a pattern of user activity from a plurality of patterns stored in the pattern database 120 based on the type of view. The pattern of user activity may vary from one view to other view. Also, the pattern of user activity may vary from one type of editor to another type of editor. The pattern of user activity may vary from one user to another user. Similarly, the pattern of user activity may vary from one engineering configuration to another. Thus, the engineering station 100 identifies pattern of user activity from the pattern database 120 based on the type of view, the user information, type of engineering configuration being created, and type of editor used.

For example, since the user has opened the device view 506, the engineering station 100 identifies the pattern of user activity associated with the hardware configuration for the device view 506. Also, the engineering station 100 determines user action being performed by the user following opening of the device view 506 in the editor window 502 in the pattern of user activity. For example, the determined user action indicates that CPU was used following opening of the device view 506. Also, the determined user action in the pattern of user activity may indicate element identifier(s) corresponding to the CPU. The engineering station 100 obtains element identifiers associated with the CPU from the determined user action in the pattern of user activity. For the purpose of illustration, consider that the element identifiers are CPU 1 2AJ10, CPU 2 6BF03, and CPU 3 6EH04. Also, consider that the CPU 1 2AJ10, CPU 2 6BF03, and CPU 3 6EH04 is used four times, three times, and two times respectively in previous engineering configurations.

The engineering station 100 obtains rank associated with the CPU 1 2AJ10, CPU 2 6BF03, and CPU 3 6EH04 from the rank database 122. The CPU 1 2AJ10 is ranked highest compared to CPU 2 6BF03 since CPU 1 2AJ10 is used four times and CPU 2 6BF03 used three times. Also, the engineering station 100 obtains graphical objects 508 representing the CPU 1 2AJ10, CPU 2 6BF03, and CPU 3 6EH04 from the elements database 118. Accordingly, the engineering station 100 dynamically displays the graphical objects 508 corresponding to the CPU 1 2AJ10, CPU 2 6BF03, and CPU 3 6EH04 in the element library window 504 according to their rank. Thus, the user can select any of the recommended graphical objects 508 representing the CPU 1 2AJ10, CPU 2 6BF03, and CPU 3 6EH04 for use in the engineering configuration. It can be seen that the CPU 1 2AJ10 is placed at the top followed by CPU 2 6BF03 then by CPU 3 6EH04. This assists the user in selecting the best ranked CPU for use in the engineering configuration. If the user does not wish to use the recommended CPUs, then the user can search for desired CPU using a search query box 510.

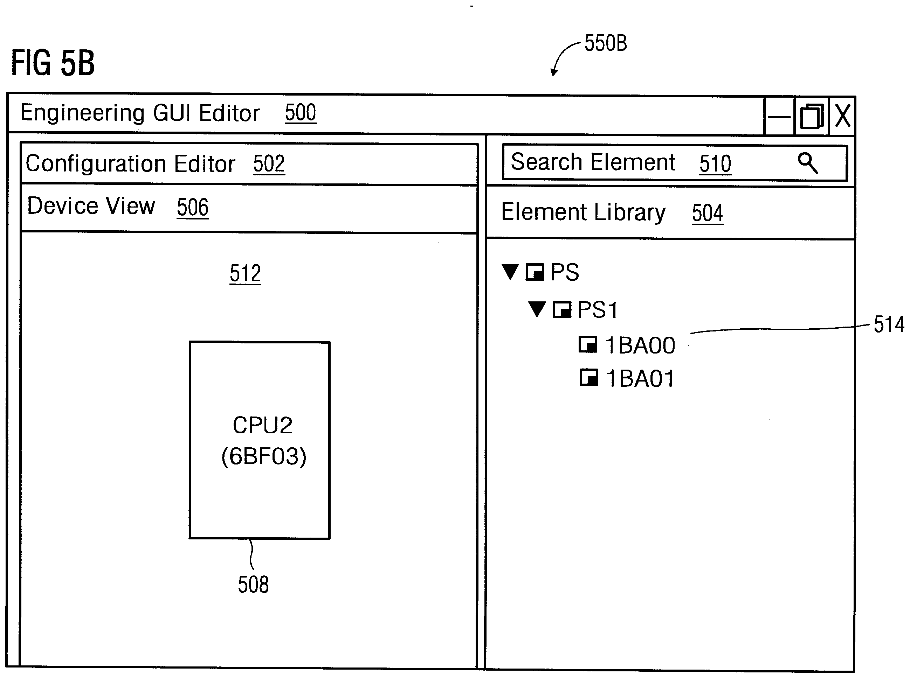

Now consider that the user selects the graphical object 508 representing CPU 2 6BF03 for use in the engineering configuration. The engineering station 100 activates and transfers the graphical object 508 representing CPU 2 6BF03 from the element library window 504 into the hardware configuration 512 displayed in the device view 506. Based on this, the engineering station 100 determines user action following selection of the CPU 2 6BF03 using the pattern of user activity. Consider that, from the pattern of user activity, the engineering station 100 determines that the user has selected a power supply (PS) following the selection of CPU. The engineering station 100 determines different types of power supplies compatible with the CPU 2 6BF03 and previously used by the user along with their rank. Also, the engineering station 100 obtains graphical objects 514 representing the different types of power supply (PS). Consider that the engineering station 100 found that the user previously used PS 1 1BA00 and PS 1 1BA01 following selection of CPU 2 6BF03, where PS 1 1BA00 is ranked highest than PS 1 1BA01. Accordingly, the engineering station 100 displays the graphical objects 514 representing PS 1 1BA00 and PA 1 1BA01 in the element library window 504 according to their rank as shown in FIG 5B.

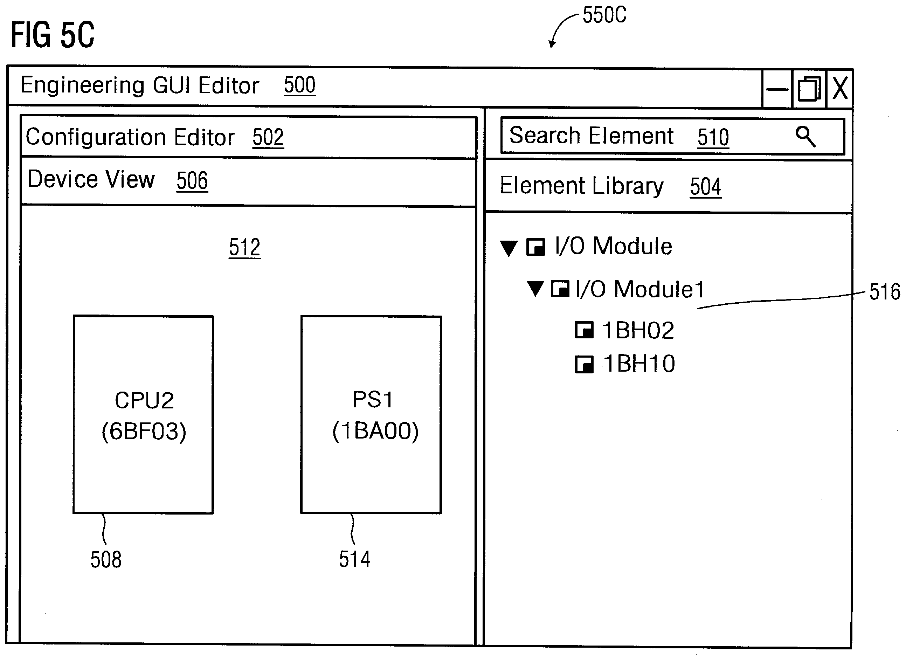

Now consider that the user selects the graphical object 514 representing PS 1 1BA00 for use in the engineering configuration. The engineering station 100 activates and transfers the graphical object 514 representing PS 1 1BA00 from the element library window 504 into the hardware configuration 512 displayed in the device view 506. Further, the engineering station 100 determines a user action following the selection of PS 1 1BA00 using the pattern of user activity. Consider that, according to the pattern of user activity, the user has previously used an I/O module following the selection of the power supply. The engineering station 100 determines that user action following the selection of power supply is selection of the I/O module using the pattern of user activity. Accordingly, the engineering station 100 determines different types of compatible I/O module previously used after selection of the power supply. Consider that the I/O modules plugged after the PS 1 1AB00 are I/O module 1 1BH02 and I/O module 2 1BH10. The engineering station 100 obtains graphical objects 516 representing the I/O module 1 1BH02 and the I/O module 1 1BH10 from the elements database 122. Then, the engineering station 100 displays the graphical objects 516 representing the I/O module 1 1BH02 and the I/O module 2 1BH10 in the element library window 504 based on their rank as shown in FIG 5C. As can be seen, the I/O module 1 1BH02 is ranked higher than the I/O module 1 1BH10 and hence associated graphical object 516 is displayed on the top in the element library window 504. This assists the user in selecting a frequently used compatible I/O module for use in the engineering configuration. In this manner, the engineering station 102 intelligently recommends elements, suitable for use in engineering configuration being created, in the element library window 504 based on a currently performed user action.

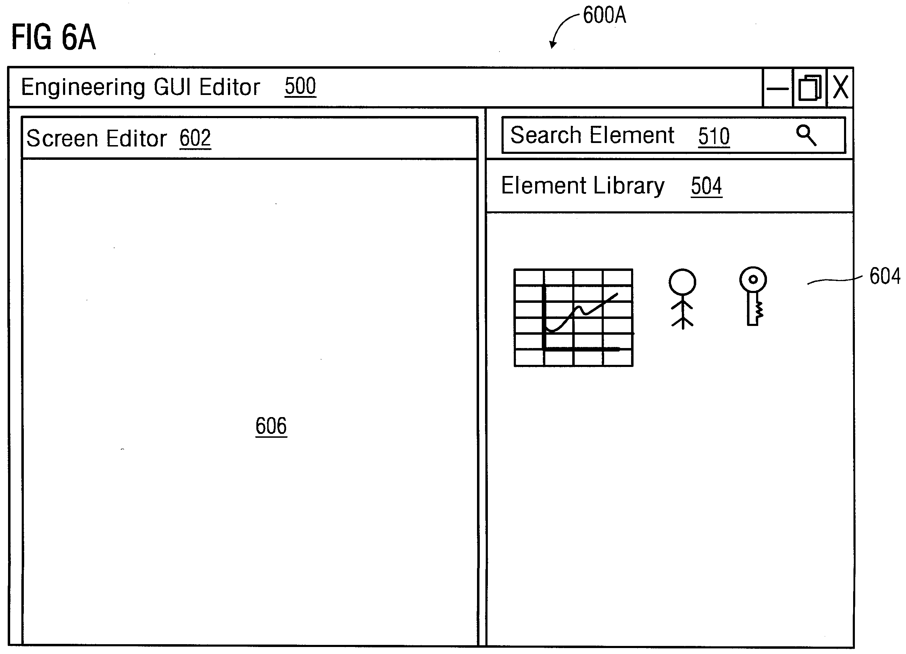

FIGs 6A-6B are screenshot views 600A and 600B of the engineering GUI editor 500 displaying a screen editor window 602 on the engineering station 100 according to another embodiment of the present invention. Consider that a user wishes to create a HMI screen 606 using the engineering GUI editor 500. Also, consider that the user opens a HMI screen 606 in the screen editor window 602. The screen editor window 602 displaying the HMI screen 606 is shown in FIG 6A. The engineering station 100 determines a pattern of user activity associated with generation of the HMI screen 606. Further, the engineering station 100 determines user action performed following the opening of HMI screen 606 according to the determined pattern of user activity. Consider that, according to the pattern of user activity, the user uses a control element for use in the HMI screen 606. Thus, the engineering station 100 determines different types of the control element previously used by the user according to the pattern of user activity. Further, the engineering station 100 determines rank associated with the different types of the control element from the rank database 122. The engineering station 100 also obtains graphical objects 604 representing the different types of the control element from the elements database 118 and displays the graphical objects 604 in the element library window 504 according to their ranks.

Now consider that the user has selected one of the graphical objects 604 for use in the HMI screen 606. For example, the user may drag and drop the desired graphical object 604 from the element library window 504 into the editor window 502. Accordingly, the engineering station 100 activates and transfers the graphical object 604 from the element library window 504 into the HMI screen 606 as shown in FIG 6A.

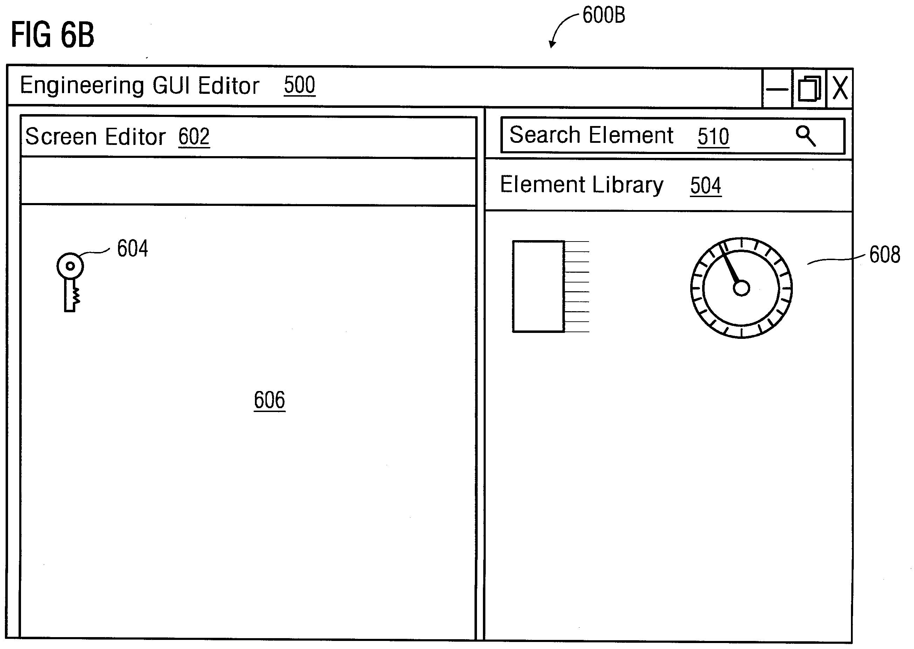

Following this, the engineering station 100 determines user action performed after selecting the graphical object 604 representing the control element using the pattern of user activity. Consider that the pattern of user activity indicates that a runtime element is selected after selecting the control element. Thus, the engineering station 100 determines different types of runtime element from the pattern of user activity. Also, the engineering station 100 determines rank associated with the different types of runtime element and obtains graphical objects 608 representing the different types of runtime element. Then, the engineering station 100 displays the graphical objects 608 representing the different types of runtime element in the element library window 504 as shown in FIG 6B. In this manner, the engineering station 100 dynamically recommends graphical objects representing elements to the user in the element library window 504 for use in HMI screens based on currently performed user action.

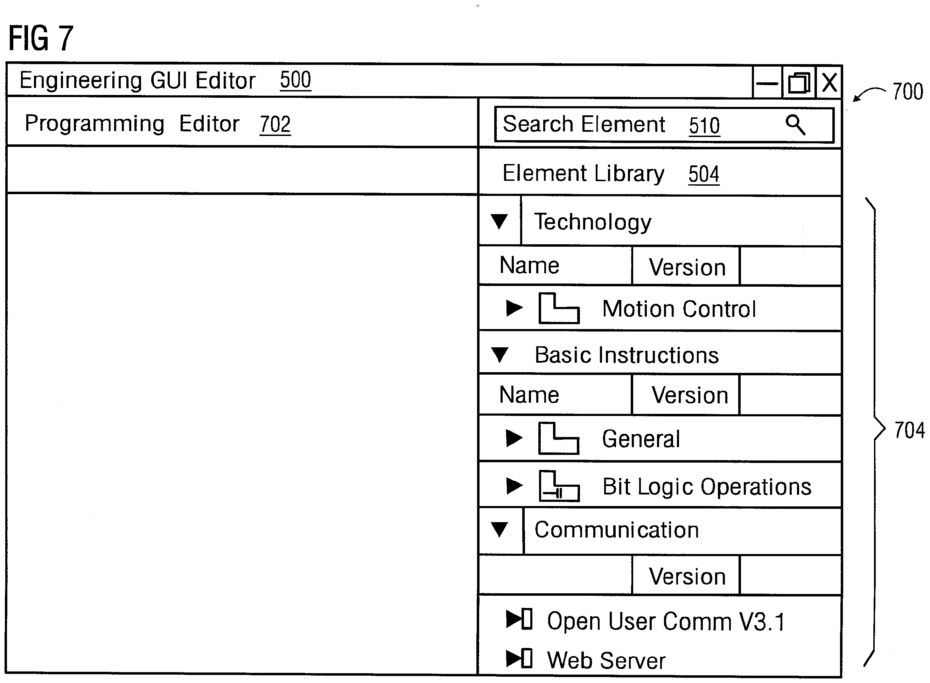

FIG 7 illustrates a screenshot view 700 of the engineering GUI editor 500 displaying a programming editor window 702 on the engineering station 100 according to yet another embodiment of the present invention. When a user opens the programming editor window 702 in the engineering GUI editor 500, the engineering station 100 detects that the programming editor window 702 is opened by the user and identifies a pattern of user activity associated with the user for creating a programming logic. Based on the pattern of user activity, the engineering station 100 determines user action that is likely to be performed following opening of the programming editor window 702. Accordingly, the engineering station 100 displays programming elements 704 likely to be used after opening of the programming editor 702 in the element library 504 as shown in FIG 7. The user may select any one of the programming elements 704 for use in the programming logic being created using the programming editor window 702. In case, the user chooses one of the programming elements 704 for use in the programming logic, then the engineering station 100 determines a next programming element likely to be used in the programming logic based on the selected programming element 704 using the pattern of user activity. In this manner, the programming elements are dynamically recommended based on currently selected programming element for use in the programming logic.

It can be noted that, the element library 504 may consist of a first display area which displays graphical objects representing elements searched by the user and a second display area which displays graphical objects representing dynamically recommended elements suitable for use in an engineering configuration being created by the user. Further, it can be noted that the element library 504 dynamically recommends a list of elements likely to be used during creation of the engineering configuration based on a pattern of user activity.

The present invention can take a form of a computer program product comprising program modules accessible from computer-usable or computer-readable medium storing program code for use by or in connection with one or more computers, processors, or instruction execution system. For the purpose of this description, a computer-usable or computer-readable medium can be any apparatus that can contain, store, communicate, propagate, or transport the program for use by or in connection with the instruction execution system, apparatus, or device. The medium can be electronic, magnetic, optical, electromagnetic, infrared, or semiconductor system (or apparatus or device) or a propagation mediums in and of themselves as signal carriers are not included in the definition of physical computer-readable medium include a semiconductor or solid state memory, magnetic tape, a removable computer diskette, random access memory (RAM), a read only memory (ROM), a rigid magnetic disk and optical disk such as compact disk read-only memory (CD-ROM), compact disk read/write, and DVD. Both processors and program code for implementing each aspect of the technology can be centralized or distributed (or a combination thereof) as known to those skilled in the art.

While the present invention has been described in detail with reference to certain embodiments, it should be appreciated that the present invention is not limited to those embodiments. In view of the present disclosure, many modifications and variations would be present themselves, to those skilled in the art without departing from the scope of the various embodiments of the present invention, as described herein. The scope of the present invention is, therefore, indicated by the following claims rather than by the foregoing description. All changes, modifications, and variations coming within the meaning and range of equivalency of the claims are to be considered within their scope.

## Claims

1. A method for creating a hardware engineering configuration (512, 606) for an automation system, by using an engineering application (112) of an engineering station (100) comprising an engineering creation module (114) and an element library module (116), by selecting one or more elements of a plurality of elements stored in the element library module (116), the elements representing hardware devices of the automation system and being displayed as graphical objects on a graphical user interface screen, comprising:
1.1 detecting, using a processor (102) of the engineering station (100), at least one user action associated with the creation of the engineering configuration (512, 606), each user action performed on the graphical user interface screen of the engineering application (112) and causing a predetermined editing event on the graphical user interface screen for creating the engineering configuration;
1.2 determining a pattern of user activity associated with creation of the engineering configuration (512, 606) from a plurality of patterns of user activity stored in a pattern data base (120) based on the detected at least one user action, wherein each of the stored patterns of user activity comprises a sequence of editing events corresponding to user actions performed in a sequential order during creation of previous engineering configurations (512, 606) or are pre-stored based on user actions likely to be performed to create a known engineering configuration;
1.3 dynamically determining at least one element for the engineering configuration (512, 606) from the plurality of elements in response to the user action based on the pattern of user activity by the element library module (116) causing the processor (102) to obtain graphical objects representing different types of the determined element from the element library module (118) and display the different types of graphical objects in an element library window based on rank associated with the different types of the element; and
the user selecting a specific type of the different types displayed in the element library window for the engineering configuration; and
1.4 displaying the selected graphical object (508) representing the at least one element on the graphical user interface screen (108) for use in the engineering configuration (512, 606); and
1.5 creating the engineering configuration (512, 606) using the at least one element.

2. The method according to claim 1, further comprising:
detecting selection of the graphical object (508) representing the at least one element for use in the engineering configuration (512, 606); and
activating and transferring the selected graphical object in an editor window (502, 602, 702) displayed on the graphical user interface screen (108).

3. The method according to claim 1 or 2, further comprising:
updating rank associated with the at least one element associated with the selected graphical object (508) in a rank database (122) .

4. The method according to claim 1, wherein dynamically determining the at least one element based on the pattern of user activity associated with the engineering configuration (512, 606) comprises:
identifying the detected user action among the series of user actions in the determined pattern of user activity; and
dynamically determining the at least one element which was previously used following the detected user action according to the determined pattern of user activity.

5. The method according to claim 4, wherein determining the pattern of user activity associated with the engineering configuration (512, 606) based on the pre-defined criteria comprises:
determining the pattern of user activity based on type of the engineering configuration (512, 606) being created.

6. The method according to claim 4 or 5, wherein dynamically determining the at least one element according to the determined pattern of user activity comprises:
determining different types of the element that were used following the detected user action using the pattern of user activity.

7. The method according to claim 1, further comprising:
dynamically updating the graphical user interface screen (108) displaying the graphical object (508) representing the at least one element based on the detected user action.

8. The method according to claim 1, further comprising:
capturing a series of events corresponding to user actions performed by the user during creation of engineering configurations (512, 606), wherein the series of events corresponding to user actions represents the pattern of user activity, and wherein each of the series of user actions is indicative of different types of the element used by the user during creation of the engineering configurations (512, 606).

9. The method according to claim 1 or 7, further comprising:
updating the pattern of user activity associated with the engineering configuration (512, 606).

10. An apparatus (100, 404A-N) for creating a hardware engineering configuration (512, 606) for an automation system, the apparatus including an engineering application (112) comprising an engineering creation module (114) and an element library module (116) by selecting one or more elements of a plurality of elements stored in the element library module (116), the elements representing hardware devices of the automation system and being displayed as graphical objects on a graphical user interface screen, further comprising:
i) a processor (102); and
ii) a memory (104) coupled to the processor (102), wherein the memory (104) comprises the engineering application (112) capable of:
1.1 detecting, using a processor (102) of the engineering station (100), at least one user action associated with the creation of the engineering configuration (512, 606), each user action performed on the graphical user interface screen of the engineering application (112) and causing a predetermined editing event on the graphical user interface screen for creating the engineering configuration;
1.2 determining a pattern of user activity associated with creation of the engineering configuration (512, 606) from a plurality of patterns of user activity stored in a pattern data base (120) based on the detected at least one user action, wherein each of the stored patterns of user activity comprises a sequence of editing events corresponding to user actions performed in a sequential order during creation of previous engineering configurations (512, 606) or are pre-stored based on user actions likely to be performed to create a known engineering configuration;
1.3 dynamically determining at least one element for the engineering configuration (512, 606) from the plurality of elements in response to the user action based on the pattern of user activity by the element library module (116) causing the processor (102) to obtain graphical objects representing different types of the determined element from the element library module (118) and display the different types of graphical objects in an element library window based on rank associated with the different types of the element; and
the user selecting a specific type of the different types displayed in the element library window for the engineering configuration; and
1.4 displaying the selected graphical object (508) representing the at least one element on the graphical user interface screen (108) for use in the engineering configuration (512, 606); and
1.5 creating the engineering configuration (512, 606) using the at least one element.

11. The apparatus (100, 404A-N) according to claim 10, wherein the engineering application (112) is capable of:
detecting selection of the graphical object (508) representing the at least one element for use in the engineering configuration (512, 606); and
activating and transferring the selected graphical object in an editor window (502, 602, 702).

12. The apparatus (100, 404A-N) according to claim 10, wherein the engineering application (112) is capable of:
capturing a series of events corresponding to user actions performed by the user during creation of engineering configurations (512, 606), wherein the series of events corresponding to user actions represents the pattern of user activity and wherein each of the series of user actions is indicative of different types of the element used by the user during creation of the engineering configurations (512, 606).

13. The apparatus (100, 404A-N) according to claim 10 or 11, wherein in displaying the graphical object (508) representing the at least one element, the engineering application (112) is capable of:
displaying graphical objects (508) representing different types of the element based on rank associated with the different types of the element.

14. The method of claim 1, wherein in feature 1.2 the event may indicate an element that is to be used for creating the engineering configuration or a view opened by the user during the creation of the engineering configuration and wherein the element library module (116) causes the processor (102) to also store type of view associated with the recorded patterns of activity in the pattern data base (122).

15. The apparatus of claim 10, wherein in feature 1.2 the event may indicate an element that is to be used for creating the engineering configuration or a view opened by the user during the creation of the engineering configuration and wherein the element library module (116) causes the processor (102) to also store type of view associated with the recorded patterns of activity in the pattern data base (122).

16. The method of claim 1, wherein in feature 1.3 the rank being assigned to each type of the displayed element based on number of times said each type of the element was previously used for creating engineering configurations.

17. The apparatus of claim 10, wherein in feature 1.3 the rank being assigned to each type of the displayed element based on number of times said each type of the element was previously used for creating engineering configurations.

## Patentansprüche

1. Verfahren zum Erzeugen einer technischen Konfiguration von Hardware (512, 606) für ein Automatisierungssystem durch Verwenden einer technischen Anwendung (112) einer technischen Station (100), die ein technisches Erzeugungsmodul (114) und ein Elementbibliotheksmodul (116) umfasst, und durch Auswählen eines oder mehrerer Elemente mehrerer in dem Elementbibliotheksmodul (116) gespeicherter Elemente, wobei die Elemente Hardware-Vorrichtungen des Automatisierungssystems repräsentieren und als graphische Objekte auf einem Bildschirm einer graphischen Anwenderschnittstelle angezeigt werden, das Folgendes umfasst:
1.1 Detektieren unter Verwendung eines Prozessors (102) der technischen Station (100) mindestens einer Anwenderhandlung, die der Erzeugung der technischen Konfiguration (512, 606) zugeordnet ist, wobei jede Anwenderhandlung auf dem Bildschirm der graphischen Anwenderschnittstelle der technischen Anwendung (112) ausgeführt wird und ein vorbestimmtes Editierereignis auf dem Bildschirm der graphischen Anwenderschnittstelle zum Erzeugen der technischen Konfiguration bewirkt;
1.2 Bestimmen eines Musters einer Anwenderaktivität, das der Erzeugung der technischen Konfiguration (512, 606) zugeordnet ist, aus mehreren Mustern einer Anwenderaktivität, die in einer Musterdatenbank (120) gespeichert sind, anhand der detektierten mindestens einen Anwenderhandlung, wobei jedes der gespeicherten Muster einer Anwenderaktivität eine Folge von Editierereignissen umfasst, die Anwenderhandlungen entsprechen, die in einer aufeinanderfolgenden Reihenfolge während der Erzeugung vorheriger technischer Konfigurationen (512, 606) ausgeführt wurden, oder im Voraus anhand von Anwenderhandlungen, die wahrscheinlich ausgeführt werden, um eine bekannte technische Konfiguration zu erzeugen, gespeichert sind;
1.3 dynamisches Bestimmen mindestens eines Elements für die technische Konfiguration (512, 606) aus den mehreren Elementen als Reaktion auf die Anwenderhandlung anhand des Musters einer Anwenderaktivität durch das Elementbibliotheksmodul (116), das bewirkt, dass der Prozessor (102) graphische Objekte, die verschiedene Typen des bestimmten Elements repräsentieren, von dem Elementbibliotheksmodul (118) erhält und die verschiedenen Typen von graphischen Objekten in einem Elementbibliotheksfenster anhand eines Rangs, der den verschiedenen Typen des Elements zugeordnet ist, anzeigt; und
Auswählen durch den Anwender eines spezifischen Typs der verschiedenen Typen, die in dem Elementbibliotheksfenster angezeigt werden, für die technische Konfiguration; und
1.4 Anzeigen des ausgewählten graphischen Objekts (508), das das mindestens eine Element repräsentiert, auf dem Bildschirm der graphischen Anwenderschnittstelle (108) für eine Verwendung in der technischen Konfiguration (512, 606); und
1.5 Erzeugen der technischen Konfiguration (512, 606) unter Verwendung des mindestens einen Elements.

2. Verfahren nach Anspruch 1, das ferner Folgendes umfasst:
Detektieren einer Auswahl des graphischen Objekts (508), das das mindestens eine Element repräsentiert, für eine Verwendung in der technischen Konfiguration (512, 606); und
Aktivieren und Übertragen des ausgewählten graphischen Objekts in ein Editor-Fenster (502, 602, 702), das auf dem Bildschirm der graphischen Anwenderschnittstelle (108) angezeigt wird.

3. Verfahren nach Anspruch 1 oder 2, das ferner Folgendes umfasst:
Aktualisieren des Rangs, der dem mindestens einen Element zugeordnet ist, das dem ausgewählten graphischen Objekt (508) zugeordnet ist, in einer Rangdatenbank (122).

4. Verfahren nach Anspruch 1, wobei das dynamische Bestimmen des mindestens einen Elements anhand des Musters einer Anwenderaktivität, das der technischen Konfiguration (512, 606) zugeordnet ist, Folgendes umfasst:
Identifizieren der detektierten Anwenderhandlung unter der Reihe von Anwenderhandlungen in dem bestimmten Muster einer Anwenderaktivität; und
dynamisches Bestimmen des mindestens einen Elements, das vorher verwendet wurde, im Anschluss an die detektierte Anwenderhandlung gemäß dem bestimmten Muster einer Anwenderaktivität.

5. Verfahren nach Anspruch 4, wobei das Bestimmen, anhand der vordefinierten Kriterien, des Musters einer Anwenderaktivität, das der technischen Konfiguration (512, 606) zugeordnet ist, Folgendes umfasst:
Bestimmen des Musters einer Anwenderaktivität anhand des Typs der technischen Konfiguration (512, 606), die erzeugt wird.

6. Verfahren nach Anspruch 4 oder 5, wobei das dynamische Bestimmen des mindestens einen Elements gemäß dem bestimmten Muster einer Anwenderaktivität Folgendes umfasst:
Bestimmen verschiedener Typen des Elements, die im Anschluss an die detektierte Anwenderhandlung verwendet wurden, unter Verwendung des Musters einer Anwenderaktivität.

7. Verfahren nach Anspruch 1, das ferner Folgendes umfasst:
dynamisches Aktualisieren des Bildschirms der graphischen Anwenderschnittstelle (108), die das graphische Objekt (508) anzeigt, das das mindestens eine Element repräsentiert, anhand der detektierten Anwenderhandlung.

8. Verfahren nach Anspruch 1, das ferner Folgendes umfasst:
Aufnehmen einer Reihe von Ereignissen, die Anwenderhandlungen entsprechen, die durch den Anwender während der Erzeugung der technischen Konfigurationen (512, 606) ausgeführt werden, wobei die Reihe von Ereignissen, die den Anwenderhandlungen entsprechen, das Muster einer Anwenderaktivität repräsentiert und wobei jede der Reihe von Anwenderhandlungen verschiedene Typen des Elements angibt, das durch den Anwender während der Erzeugung der technischen Konfigurationen (512, 606) verwendet wird.

9. Verfahren nach Anspruch 1 oder 7, das ferner Folgendes umfasst:
Aktualisieren des Musters einer Anwenderaktivität, das der technischen Konfiguration (512, 606) zugeordnet ist.

10. Vorrichtung (100, 404A-N) zum Erzeugen einer technischen Konfiguration von Hardware (512, 606) für ein Automatisierungssystem, wobei die Vorrichtung eine technische Anwendung (112) enthält, die ein technisches Erzeugungsmodul (114) und ein Elementbibliotheksmodul (116) umfasst, durch Auswählen eines oder mehrerer Elemente mehrerer in dem Elementbibliotheksmodul (116) gespeicherter Elemente, wobei die Elemente Hardware-Vorrichtungen des Automatisierungssystems repräsentieren und als graphische Objekte auf einem Bildschirm einer graphischen Anwenderschnittstelle angezeigt werden, die ferner Folgendes umfasst:
i) einen Prozessor (102); und
ii) einen Speicher (104), der an den Prozessor (102) gekoppelt ist, wobei der Speicher (104) die technische Anwendung (112) umfasst, die befähigt ist zum:
1.1 Detektieren unter Verwendung eines Prozessors (102) der technischen Station (100), wobei mindestens eine Anwenderhandlung der Erzeugung der technischen Konfiguration (512, 606) zugeordnet ist, wobei jede Anwenderhandlung auf dem Bildschirm der graphischen Anwenderschnittstelle der technischen Anwendung (112) ausgeführt wird und ein vorbestimmtes Editierereignis auf dem Bildschirm der graphischen Anwenderschnittstelle zum Erzeugen der technischen Konfiguration bewirkt;
1.2 Bestimmen eines Musters einer Anwenderaktivität, das der Erzeugung der technischen Konfiguration (512, 606) zugeordnet ist, aus mehreren Mustern einer Anwenderaktivität, die in einer Musterdatenbank (120) gespeichert sind, anhand der detektierten mindestens einen Anwenderhandlung, wobei jedes der gespeicherten Muster einer Anwenderaktivität eine Folge von Editierereignissen umfasst, die Anwenderhandlungen entsprechen, die in einer aufeinanderfolgenden Reihenfolge während der Erzeugung vorheriger technischer Konfigurationen (512, 606) ausgeführt wurden, oder im Voraus anhand von Anwenderhandlungen, die wahrscheinlich ausgeführt werden, um eine bekannte technische Konfiguration zu erzeugen, gespeichert sind;
1.3 dynamisches Bestimmen mindestens eines Elements für die technische Konfiguration (512, 606) aus den mehreren Elementen als Reaktion darauf, dass die Anwenderhandlung anhand des Musters einer Anwenderaktivität durch das Elementbibliotheksmodul (116) bewirkt, dass der Prozessor (102) graphische Objekte, die verschiedene Typen des bestimmten Elements repräsentieren, von dem Elementbibliotheksmodul (118) erhält und die verschiedenen Typen von graphischen Objekten in einem Elementbibliotheksfenster anhand eines Rangs, der den verschiedenen Typen des Elements zugeordnet ist, anzeigt; und
Auswählen durch den Anwender eines spezifischen Typs der verschiedenen Typen, die in dem Elementbibliotheksfenster angezeigt werden, für die technische Konfiguration; und
1.4 Anzeigen des ausgewählten graphischen Objekts (508), das das mindestens eine Element repräsentiert, auf dem Bildschirm der graphischen Anwenderschnittstelle (108) für eine Verwendung in der technischen Konfiguration (512, 606); und
1.5 Erzeugen der technischen Konfiguration (512, 606) unter Verwendung des mindestens einen Elements.

11. Vorrichtung (100, 404A-N) nach Anspruch 10, wobei die technische Anwendung (112) befähigt ist zum:
Detektieren einer Auswahl des graphischen Objekts (508), das das mindestens eine Element repräsentiert, für eine Verwendung in der technischen Konfiguration (512, 606); und
Aktivieren und Übertragen des ausgewählten graphischen Objekts in ein Editor-Fenster (502, 602, 702).

12. Vorrichtung (100, 404A-N) nach Anspruch 10, wobei die technische Anwendung (112) befähigt ist zum:
Aufnehmen einer Reihe von Ereignissen, die Anwenderhandlungen entsprechen, die durch den Anwender während der Erzeugung der technischen Konfigurationen (512, 606) ausgeführt werden, wobei die Reihe von Ereignissen, die den Anwenderhandlungen entsprechen, das Muster einer Anwenderaktivität repräsentiert und wobei jede der Reihe von Anwenderhandlungen verschiedene Typen des Elements angibt, das durch den Anwender während der Erzeugung der technischen Konfigurationen (512, 606) verwendet wird.

13. Vorrichtung (100, 404A-N) nach Anspruch 10 oder 11, wobei beim Anzeigen des graphischen Objekts (508), das das mindestens eine Element repräsentiert, die technische Anwendung (112) befähigt ist zum:
Anzeigen graphischer Objekte (508), die verschiedene Typen des Elements repräsentieren, anhand eines Rangs, der den verschiedenen Typen des Elements zugeordnet ist.

14. Verfahren nach Anspruch 1, wobei in Merkmal 1.2 das Ereignis ein Element, das für die Erzeugung der technischen Konfiguration zu verwenden ist, oder eine Sicht, die durch den Anwender während der Erzeugung der technischen Konfiguration geöffnet wird, angeben kann und wobei das Elementbibliotheksmodul (116) bewirkt, dass der Prozessor (102) auch einen Typ der Sicht, der den aufgenommenen Mustern der Aktivität zugeordnet ist, in der Musterdatenbank (122) speichert.

15. Vorrichtung nach Anspruch 10, wobei in Merkmal 1.2 das Ereignis ein Element, das für die Erzeugung der technischen Konfiguration zu verwenden ist, oder eine Sicht, die durch den Anwender während der Erzeugung der technischen Konfiguration geöffnet wird, angeben kann und wobei das Elementbibliotheksmodul (116) bewirkt, dass der Prozessor (102) auch den Typ der Sicht, der den aufgenommenen Mustern der Aktivität zugeordnet ist, in der Musterdatenbank (122) speichert.

16. Verfahren nach Anspruch 1, wobei in Merkmal 1.3 der Rang jedem Typ des angezeigten Elements anhand einer Häufigkeit, mit der jeder Typ des Elements vorher für die Erzeugung von technischen Konfigurationen verwendet wurde, zugewiesen wird.

17. Vorrichtung nach Anspruch 10, wobei in Merkmal 1.3 der Rang jedem Typ des angezeigten Elements anhand einer Häufigkeit, mit der jeder Typ des Elements vorher für die Erzeugung von technischen Konfigurationen verwendet wurde, zugewiesen wird.

## Revendications

1. Procédé de création d'une configuration technique matérielle (512, 606) pour un système d'automatisation, en utilisant une application d'ingénierie (112) d'un poste d'ingénierie (100) comprenant un module de création technique (114) et un module de bibliothèque d'éléments (116), en sélectionnant un ou plusieurs éléments d'une pluralité d'éléments stockés dans le module de bibliothèque d'éléments (116), les éléments représentant des dispositifs matériels du système d'automatisation et étant affichés en tant qu'objets graphiques sur un écran d'interface utilisateur graphique, comprenant :
1.1 la détection, à l'aide d'un processeur (102) du poste d'ingénierie (100), d'au moins une action d'utilisateur associée à la création de la configuration technique (512, 606), chaque action d'utilisateur étant réalisée sur l'écran d'interface utilisateur graphique de l'application d'ingénierie (112) et provoquant un événement de modification prédéterminé sur l'écran d'interface utilisateur graphique pour créer la configuration technique ;
1.2 la détermination d'un schéma d'activité d'utilisateur associé à la création de la configuration technique (512, 606) parmi une pluralité de schémas d'activité d'utilisateur stockée dans une base de données de schémas (120) en fonction de l'au moins une action d'utilisateur détectée, dans lequel chacun des schémas d'activité d'utilisateur stockés comprend une séquence d'événements de modification correspondant à des actions d'utilisateur réalisées dans un ordre séquentiel durant la création de configurations techniques antérieures (512, 606) ou sont préstockés en fonction d'actions d'utilisateur susceptibles d'être réalisées pour créer une configuration technique connue ;
1.3 la détermination dynamique d'au moins un élément de la configuration technique (512, 606) parmi la pluralité d'éléments en réponse à l'action d'utilisateur en fonction du schéma d'activité d'utilisateur par le module de bibliothèque d'éléments (116) amenant le processeur (102) à obtenir des objets graphiques représentant différents types de l'élément déterminé à partir du module de bibliothèque d'éléments (118) et à afficher les différents types d'objets graphiques dans une fenêtre de bibliothèque d'éléments en fonction d'un rang associé aux différents types de l'élément ; et
l'utilisateur sélectionnant un type spécifique des différents types affichés dans la fenêtre de bibliothèque d'éléments pour la configuration technique ; et
1.4 l'affichage de l'objet graphique sélectionné (508) représentant l'au moins un élément sur l'écran d'interface utilisateur graphique (108) en vue de son utilisation dans la configuration technique (512, 606) ; et
1.5 la création de la configuration technique (512, 606) à l'aide de l'au moins un élément.

2. Procédé selon la revendication 1, comprenant en outre :
la détection d'une sélection de l'objet graphique (508) représentant l'au moins un élément pour son utilisation dans la configuration technique (512, 606) ; et
l'activation et le transfert de l'objet graphique sélectionné dans une fenêtre de modification (502, 602, 702) affichée sur l'écran d'interface utilisateur graphique (108).

3. Procédé selon la revendication 1 ou 2, comprenant en outre :
l'association du rang associé à l'au moins un élément associé à l'objet graphique sélectionné (508) dans une base de données de rangs (122).

4. Procédé selon la revendication 1, dans lequel la détermination dynamique de l'au moins un élément en fonction du schéma d'activité d'utilisateur associé à la configuration technique (512, 606) comprend :
l'identification de l'action d'utilisateur détectée parmi la série d'actions d'utilisateur dans le schéma d'activité d'utilisateur déterminé ; et
la détermination dynamique de l'au moins un élément qui a été précédemment utilisé après l'action d'utilisateur détectée conformément au schéma d'activité d'utilisateur déterminé.

5. Procédé selon la revendication 4, dans lequel la détermination du schéma d'activité d'utilisateur associé à la configuration technique (512, 606) en fonction des critères prédéfinis comprend :
la détermination du schéma d'activité d'utilisateur en fonction du type de la configuration technique (512, 606) en cours de création.

6. Procédé selon la revendication 4 ou 5, dans lequel la détermination dynamique de l'au moins un élément conformément au schéma d'activité d'utilisateur déterminé comprend :
la détermination de différents types de l'élément qui ont été utilisés après l'action d'utilisateur détectée en utilisant le schéma d'activité d'utilisateur.

7. Procédé selon la revendication 1, comprenant en outre :
l'actualisation dynamique de l'écran d'interface utilisateur graphique (108) affichant l'objet graphique (508) représentant l'au moins un élément en fonction de l'action d'utilisateur détectée.

8. Procédé selon la revendication 1, comprenant en outre :
la capture d'une série d'événements correspondant à des actions d'utilisateur réalisées par l'utilisateur durant la création de configurations techniques (512, 606), dans lequel la série d'événements correspondant à des actions d'utilisateur représentent le schéma d'activité d'utilisateur, et dans lequel chacune de la série d'actions d'utilisateur est indicative de différents types de l'élément utilisé par l'utilisateur durant la création des configurations techniques (512, 606) .

9. Procédé selon la revendication 1 ou 7, comprenant en outre :
l'actualisation du schéma d'activité d'utilisateur associé à la configuration technique (512, 606).

10. Appareil (100, 404A-N) de création d'une configuration technique matérielle (512, 606) pour un système d'automatisation comportant une application d'ingénierie (112) comprenant un module de création technique (114) et un module de bibliothèque d'éléments (116) en sélectionnant un ou plusieurs éléments d'une pluralité d'éléments stockés dans le module de bibliothèque d'éléments (116), les éléments représentants des dispositifs matériels du système d'automatisation étant affichés en tant qu'objets graphiques sur un écran d'interface utilisateur graphique, comprenant en outre :
i) un processeur (102) ; et
ii) une mémoire (104) couplée au processeur (102), dans lequel la mémoire (104) comprend l'application d'ingénierie (112) en mesure de :
1.1 détecter, à l'aide d'un processeur (102) du poste d'ingénierie (100), au moins une action d'utilisateur associée à la création de la configuration technique (512, 606), chaque action d'utilisateur étant réalisée sur l'écran d'interface utilisateur graphique de l'application d'ingénierie (112) et provoquant un événement de modification prédéterminé sur l'écran d'interface utilisateur graphique pour créer la configuration technique ;
1.2 déterminer un schéma d'activité d'utilisateur associé à la création de la configuration technique (512, 606) parmi une pluralité de schémas d'activité d'utilisateur stockée dans une base de données de schémas (120) en fonction de l'au moins une action d'utilisateur détectée, dans lequel chacun des schémas d'activité d'utilisateur stockés comprend une séquence d'événements de modification correspondant à des actions d'utilisateur réalisées dans un ordre séquentiel durant la création de configurations techniques antérieures (512, 606) ou sont préstockés en fonction d'actions d'utilisateur susceptibles d'être réalisées pour créer une configuration technique connue ;
1.3 déterminer dynamiquement au moins un élément de la configuration technique (512, 606) parmi la pluralité d'éléments en réponse à l'action d'utilisateur en fonction du schéma d'activité d'utilisateur par le module de bibliothèque d'éléments (116) amenant le processeur (102) à obtenir des objets graphiques représentant différents types de l'élément déterminé à partir du module de bibliothèque d'éléments (118) et à afficher les différents types d'objets graphiques dans une fenêtre de bibliothèque d'éléments en fonction d'un rang associé aux différents types de l'élément ; et
l'utilisateur sélectionnant un type spécifique des différents types affichés dans la fenêtre de bibliothèque d'éléments pour la configuration technique ; et
1.4 afficher l'objet graphique sélectionné (508) représentant l'au moins un élément sur l'écran d'interface utilisateur graphique (108) en vue de son utilisation dans la configuration technique (512, 606) ; et
1.5 créer la configuration technique (512, 606) à l'aide de l'au moins un élément.

11. Appareil (100, 404A-N) selon la revendication 10, dans lequel l'application d'ingénierie (112) est en mesure de :
détecter une sélection de l'objet graphique (508) représentant l'au moins un élément pour son utilisation dans la configuration technique (512, 606) ; et
l'activation et le transfert de l'objet graphique sélectionné dans une fenêtre de modification (502, 602, 702).

12. Appareil (100, 404A-N) selon la revendication 10, dans lequel l'application d'ingénierie (112) est en mesure de :
capturer une série d'événements correspondant à des actions d'utilisateur réalisées par l'utilisateur durant la création de configurations techniques (512, 606), dans lequel la série d'événements correspondant à des actions d'utilisateur représente le schéma d'activité d'utilisateur et dans lequel chacune de la série d'actions d'utilisateur est indicative de différents types de l'élément utilisé par l'utilisateur durant la création des configurations techniques (512, 606).

13. Appareil (100, 404A-N) selon la revendication 10 ou 11, dans lequel dans l'affichage de l'objet graphique (508) représentant l'au moins un élément, l'application d'ingénierie (112) est en mesure :
d'afficher des objets graphiques (508) représentant différent types de l'élément en fonction d'un rang associé aux différents types de l'élément.

14. Procédé selon la revendication 1, dans lequel au point 1.2 l'événement peut indiquer un élément qui doit être utilisé pour créer la configuration technique ou une vue ouverte par l'utilisateur durant la création de la configuration technique et dans lequel le module de bibliothèque d'éléments (116) amène le processeur (102) à également stocker le type de vue associé aux schémas d'activité enregistrés dans la base de données de schémas (122).

15. Appareil selon la revendication 10, dans lequel au point 1.2 l'événement peut indiquer un élément qui doit être utilisé pour créer la configuration technique ou une vue ouverte par l'utilisateur durant la création de la configuration technique et dans lequel le module de bibliothèque d'éléments (116) amène le processeur (102) à également stocker le type de vue associé aux schémas d'activité enregistrés dans la base de données de schémas (122).

16. Procédé selon la revendication 1, dans lequel au point 1.3 le rang est assigné à chaque type de l'élément affiché en fonction d'un nombre d'utilisations antérieures de chaque dit type de l'élément pour la création de configurations techniques.

17. Appareil selon la revendication 10, dans lequel au point 1.3 le rang est assigné à chaque type de l'élément affiché en fonction d'un nombre d'utilisations antérieures de chaque dit type de l'élément pour la création de configurations techniques.
